# EUROPÄISCHE PATENTANMELDUNG

(11) **EP 0 742 468 A2**
(43) Veröffentlichungstag der Anmeldung: **13.11.1996**
(21) Anmeldenummer: 96105671.0
(22) Anmeldetag: 06.04.1996
(51) Int. Cl.: G02F 1/13, H05K 3/36

(54) **Kontaktvorrichtung**

(30) Priorität: 04.05.1995 DE 19516348
(71) Anmelder: Valeo Borg Instruments Verwaltung GmbH, 75196 Remchingen (DE)
(72) Erfinder: Arheit, Thomas, 76353 Weingarten (DE)
(74) Vertreter: COHAUSZ HASE DAWIDOWICZ & PARTNER

(57) **Zusammenfassung**

Offenbart wird eine Kontaktvorrichtung zur Kontaktierung von auf der Oberfläche befindlichen Kontaktstellen einer ersten Leiterplatte 1 mit einer dazu senkrecht stehenden zweiten Leiterplatte 3 insbesondere einer Flüssigkristallanzeige, durch ein Leitgummi 12, welches zahlreiche leitende Schichten und dazwischen befindliche isolierende Schichten aufweist und durch eine isolierende Klemmvorrichtung 13 derart auf die erste Leiterplatte 1 geklemmt wird, daß es mit einer Seitenfläche die Kontaktstellen 11 berührt.

## Beschreibung

Die Erfindung betrifft eine Kontaktvorrichtung zur Kontaktierung einer ersten Leiterplatte mit einer dazu senkrecht stehenden zweiten Leiterplatte insbesondere einer Flüssigkristallanzeige, durch ein Leitgummi, das zahlreiche leitende Schichten und dazwischen befindliche isolierende Schichten aufweist.

Die senkrechte Anordnung zweier Leiterplatten hat sich insbesondere bei Flüssigkristallanzeigen und den dazugehörigen Steuerleiterplatten besonders bewährt, da bei dieser Anordnung die Rückseite der Flüssigkristallanzeige nicht von einer Leiterplatte bedeckt wird und es daher möglich ist, deren Display von der Rückseite durch eine dahinter angeordnete Lampe oder eine LED zu beleuchten.

Um die Kontaktierung der LCD-Anzeige und der dazu senkrecht stehenden Leiterplatte vorzunehmen ist es bekannt, Kontaktstifte auf das LCD aufzudrücken, zu verkleben und dann in die Leiterplatte einzulöten. Diese Art der Kontaktierung hat den Nachteil, daß sie aufwendig ist und nur bedingt maschinell durchgeführt werden kann. Durch manuelle Montagearbeiten wird jedoch der Fertigungsprozeß verteuert.

Zudem ist es grundsätzlich schwierig, auf Leiterplatten zu löten ohne daß aufgrund der lokalen Erwärmung Spannungen auftreten können, die zur Zerstörung von Bauteilen oder zum Reißen der Kontakte führen können.

Um die Kontaktierung zweier senkrecht zueinander angeordneter Leiterplatten zu vereinfachen ist bekannt, sie anstatt über starre Verbindungen, mittels eines Leitgummis zu kontaktieren. Solche Leitgummis sind auch unter der Bezeichnung Zebrastreifen bekannt. Es weist zahlreiche nebeneinanderliegende leitende Schichten mit dazwischen befindlichen isolierenden Schichten auf. Die Schichten sind elastisch, so daß das gesamte Leitgummi verformbar wird.

Insbesondere für LCD-Anzeigen wird eine derartige Kontaktierung beispielsweise in DE 35 30 827 C2 vorgeschlagen. Dabei werden an einer der beiden Leiterplatten Kontaktstreifen angebracht, die teilweise parallel zu der zweiten Leiterplatte verlaufen. Die Kontaktstreifen können in einem Winkelstecker zusammengefaßt sein. Zwischen den Kontaktstreifen und den metallischen Kontakten der zweiten Leiterplatte wird ein Leitgummi eingebracht. Das Leitgummi wird in einer Halterung, insbesondere in dem Winkelstecker geführt, der an die erste Leiterplatte angebracht ist. Das Leitgummi liegt dabei in einer Nut ein und kontaktiert mit seinen jeweiligen Stirnflächen einerseits die Kontaktstreifen der ersten und andererseits die Kontakte der Flüssigkristallanzeige.

Nachteilig bei der in DE 35 30 827 C2 vorgeschlagenen Art der Kontaktierung ist vor allem die große Anzahl von Bauelementen, die einerseits Materialkosten verursacht und andererseits zur Störanfälligkeit der Kontaktierung beiträgt. Gerade der Einsatz der genannten Kontaktstreifen ist fertigungstechnisch aufwendig und führt bei maschineller Montage leicht zu fehlerhaftem Ausschuß.

Außerdem addieren sich bei der großen Anzahl von Bauelementen mehrere Toleranzen, so daß bei der Fertigung auf eine große Präzision geachtet werden muß. Eine größere Präzision geht wiederum mit einer weiteren Erhöhung der Kosten einher.

Aufgabe der Erfindung ist es daher, eine einfache, kostengünstige und zuverlässige Kontaktierung zwischen zwei senkrecht zueinander angeordneten Leiterplatten zu schaffen.

Diese Aufgabe wird durch die kennzeichnenden Merkmale des Anspruchs 1 gelöst.

Die vorliegende Erfindung betrifft daher eine Kontaktvorrichtung zur Kontaktierung einer ersten Leiterplatte mit einer dazu senkrecht stehenden zweiten Leiterplatte insbesondere einer Flüssigkristallanzeige, durch ein Leitgummi, das zahlreiche leitende Schichten und dazwischen befindliche isolierende Schichten aufweist, dadurch gekennzeichnet,
- daß auf den Oberflächen beider Leiterplatten Kontaktstellen sind,
- daß eine isolierende Klemmvorrichtung das Leitgummi derart auf die erste Leiterplatte klemmt, daß es mit einer Seitenfläche die Kontaktstellen berührt,
- daß das Leitgummi mit einer Stirnfläche den Rand der ersten Leiterplatte überragt und
- daß die Kontaktstellen der zweiten Leiterplatte die Stirnfläche des Leitgummis kontaktieren.

Ein wichtiger Vorteil der Erfindung ist, daß auf die Kontaktstreifen verzichtet werden kann, da das Kontaktgummi einfach mit seiner Seitenfläche flach auf die auf der Leiterplatte befindlichen Kontakte gedrückt wird.

Durch die Einsparung von dazwischengeschalteten Bauteilen wie Kontaktstreifen und Winkelstecker ist eine direktere Kontaktierung zwischen dem LCD-Display und der Leiterplatte gegeben. Die einzigen beachtenswerten Toleranzen stammen daher von der Leiterplatte, dem Leitgummi und dem LCD-Display.

In einer vorteilhaften Ausführung ist das Isolierstück, das zur Führung des Leitgummis beiträgt, einteilig mit dem Lampengehäuse über ein Filmscharnier verbunden. Diese Ausführungsform reduziert den Fertigungs- und Montageaufwand und damit die Herstellungskosten beträchtlich.

Insgesamt werden also durch die Erfindung sowohl Kosten für die Bauteile als auch ein nicht unerheblicher Kostenanteil bei der Montage eingespart. Insgesamt trägt die Erfindung damit stark zur Kostensenkung bei der Herstellung von Kraftfahrzeugarmaturen, die mit LCD-Displays ausgestattet sind, bei.

Ausführungsbeispiele der Erfindung sind in den Figuren dargestellt und werden im folgenden näher beschrieben.

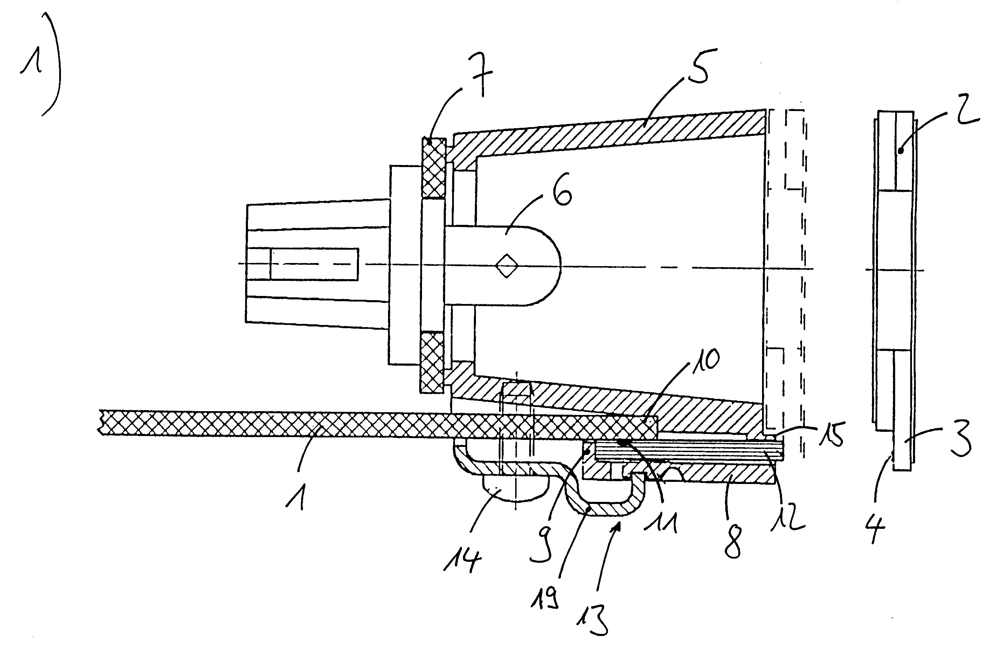

Es zeigen
- Figur 1: eine Form der Kontaktierung zwischen einer Leiterplatte und einem LCD-Display mittels eines Federelementes,
- Figur 2: eine Form der Kontaktierung zwischen einer Leiterplatte und einem LCD-Display mittels einer verschraubten isolierenden Leiste,
- Figur 3: eine Detailansicht der verschraubten isolierenden Leiste.

Auf einer ersten Leiterplatte 1 befinden sich Schaltungen, die zur Ansteuerung einer Flüssigkeitskristallanzeige (LCD-Display) 2 dienen. Die Versorgung des LCD-Displays seitens der ersten Leiterplatte 1 erfolgt über Kontaktstellen 11, die sich am Rande 10 der ersten Leiterplatte befinden.

Das LCD-Display 2 ist senkrecht zur ersten Leiterplatte 1 orientiert. Der Rand des Displays wird von einer zweiten Leiterplatte 3 überragt, auf deren zur ersten Leiterplatte 1 gerichteten Oberfläche sich ebenfalls freiliegende Kontaktstellen 4, meist in Form aufgedampfter Leiterbahnen, befinden. Die Zahl der zur Ansteuerung eines derartigen LCD-Displays 2 nötigen Kontaktstellen 4 kann sehr hoch sein, so daß die Stromübertragung durch sehr feine Leitungen mit einer hohen Dichte erfolgen muß, um den Platzbedarf zu gering zu halten.

Die elektrische Verbindung zwischen den Kontaktstellen 11 der ersten und den Kontaktstellen 4 der zweiten Leiterplatte 3 wird über ein Leitgummi 12, auch Zebrastreifen genannt, hergestellt. Dieses Leitgummi 12 ist ein flexibles Plättchen mit rechteckigem Querschnitt. Es weist eine hohe Dichte parallel liegender sehr feiner Leiterbahnen auf, die jeweils durch eine isolierende flexible Schicht elektrisch voneinander getrennt sind.

Das Leitgummi 12 wird zur Kontaktierung einerseits mit einer Seitenfläche durch eine an der ersten Leiterplatte 1 angebrachte isolierende Klemmvorrichtung 13 gegen die Kontakte 11 gedrückt, während eine Stirnfläche des Leitgummis 12 die Klemmvorrichtung 13 überragt und die Kontaktstellen 4 der zweiten Leiterplatte 3 berührt.

Die Klemmvorrichtung 13 besteht aus einem Isolierstück 8, das auf den Kontakten 11 abgewandten Seite des Leitgummis 12 aufliegt. Das Isolierstück 8 ist teilweise von einer Umrandung 9 umgeben, durch die das Leitgummi 12 geführt wird. Das Leitgummi 12 überragt das Isolierstück an der dem LCD-Display 2 zugewandten Seite, so daß eine Kontaktierung zur Leiterplatte 4 möglich ist.

Das Isolierstück 8 wird in diesem besonderen Ausführungsbeispiel von einem Federelement 20 gegen die erste Leiterplatte 1 gedrückt. Das Federelement 20 liegt mit einem Bereich auf der ersten Leiterplatte 1 und mit einem anderen Bereich auf dem Isolierstück 8 an und ist mittels eines Befestigungselementes 14 insbesondere einer Schraube an der ersten Leiterplatte befestigt. Das Leitgummi 12 wird auf die beschriebene Weise zwischen die erste Leiterplatte 1 und das Isolierstück 8 geklemmt und durch die Umrandung 9 geführt.

Auf der ersten Leiterplatte 1 auf der den Kontaktstellen 11 abgewandten Oberfläche ist ein Gehäuse 5 angebracht, das eine an der Rückseite befindliche Lichtquelle 6 in Form einer Lampe oder eines LED umgibt. Das Gehäuse 5 ist vorteilhafterweise aus Kunststoff. Die Lichtquelle 6 wird über eine extra an das Gehäuse geklemmte Leiterplatte 7 versorgt. Das Gehäuse 5 liegt mit seiner Unterseite auf der ersten Leiterplatte 1 auf und überragt die Leiterplatte 1 mit der Frontseite.

Es ist besonders vorteilhaft, das Isolierstück 8 an der unteren Kante der Frontseite des Gehäuses 5 über Filmscharniere so anzuformen, daß es gegen die Unterseite des Gehäuses 5 schwenkbar ist. Das Gehäuse 5 weist im Bereich der Filmscharniere einen Absatz 15 auf, der zur Führung des Leitgummis 12 dient. Das LCD-Display 2 wird, nachdem das Leitgummi 8 mittels der Klemmvorrichtunq montiert ist, direkt vor ein Gehäuse 5 geklemmt (unterbrochene Linie).

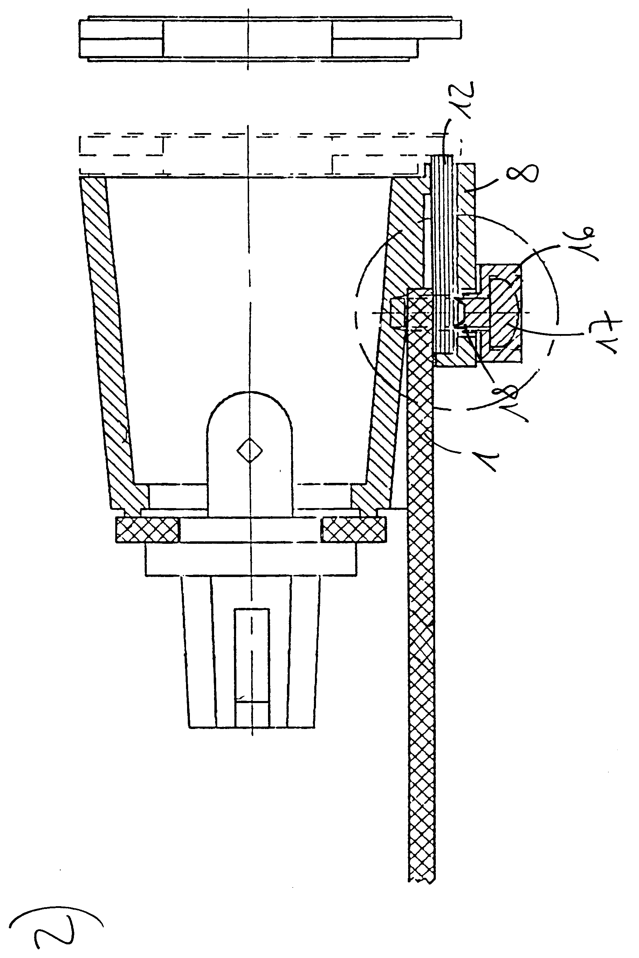

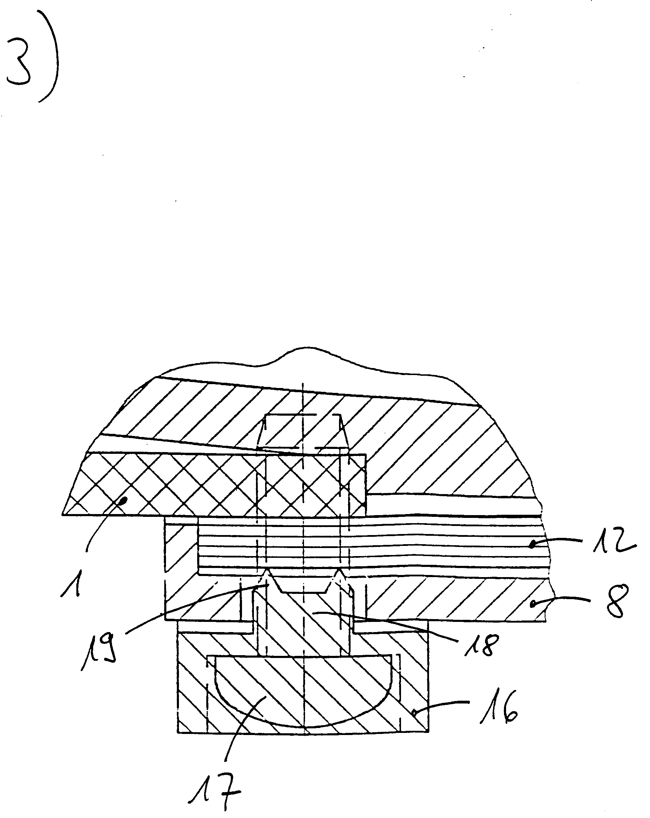

In einer anderen Ausführungsform (Figur 2) weist die Klemmvorrichtung 13 statt der Klemmfeder eine isolierende Leiste 16 auf, mit der das Isolierstück 8 gegenüber der Leiterplatte 1 mittels einer Befestigungseinrichtung insbesondere einer Schraube 17 gehaltert ist. An die Leiste 16 ist mindestens ein Fuß 18 angeformt, der eine Bohrung des Isolierstückes durchgreift und mit Klauen 19 (Figur 3) in die Oberfläche des Leitgummis 12 greift, so daß es gegen Verrutschen auf dem Isolierstück 8 gesichert ist.

## Patentansprüche

1. Kontaktvorrichtung zur Kontaktierung einer ersten Leiterplatte (1) mit einer dazu senkrecht stehenden zweiten Leiterplatte (3) insbesondere einer Flüssigkristallanzeige, durch ein Leitgummi (12), das zahlreiche leitende Schichten und dazwischen befindliche isolierende Schichten aufweist, **dadurch gekennzeichnet,**
- daß auf den Oberflächen beider Leiterplatten Kontaktstellen (4, 11) sind,
- daß eine isolierende Klemmvorrichtung (13) das Leitgummi (12) derart auf die erste Leiterplatte (1) klemmt, daß es mit einer Seitenfläche die Kontaktstellen (11) berührt,
- daß das Leitgummi (12) mit einer Stirnfläche den Rand (10) der ersten Leiterplatte (1) überragt und
- daß die Kontaktstellen (4) der zweiten Leiterplatte (3) die Stirnfläche des Leitgummis (12) kontaktieren.

2. Kontaktvorrichtung nach Anspruch 1, **dadurch gekennzeichnet,** daß die Klemmvorrichtung (13) an der ersten Leiterplatte (1) befestigt ist.

3. Kontaktvorrichtung nach Anspruch 1 oder 2, **dadurch gekennzeichnet,** daß die Klemmvorrichtung (13) ein Isolierstück (8) aufweist, auf dem die der ersten Leiterplatte (1) abgewandte Seitenfläche des Leitgummis (12) aufliegt.

4. Kontaktvorrichtung nach einem der vorherigen Ansprüche, **dadurch gekennzeichnet,** daß auf der der Klemmvorrichtung (13) abgewandten Oberfläche der ersten Leiterplatte (1) ein Gehäuse (5) für eine Lichtquelle (6), insbesondere eine Lampe oder eine LED, angebracht ist.

5. Kontaktvorrichtung nach einem der vorherigen Ansprüche, **dadurch gekennzeichnet,** daß das Isolierstück (8) beweglich insbesondere über ein Filmscharnier an das Gehäuse (5) angeformt ist.

6. Kontaktvorrichtung nach einem der vorherigen Ansprüche, **dadurch gekennzeichnet,** daß die Klemmvorrichtung (13) ein Federelement (20) aufweist, das mit einem Bereich auf dem Isolierteil (8) und mit einem anderen Bereich auf der ersten Leiterplatte (1) anliegt und mittels eines Befestigungselementes (14) insbesondere einer Schraube an der ersten Leiterplatte (1) befestigt ist.

7. Kontaktvorrichtung nach einem der vorherigen Ansprüche, **dadurch gekennzeichnet,** daß das Leitgummi (12) mittels des Federelementes (20) gegen die erste Leiterplatte (1) geklemmt ist.

8. Kontaktvorrichtung nach einem der vorherigen Ansprüche, **dadurch gekennzeichnet,** daß die Klemmvorrichtung (13) eine mit der ersten Leiterplatte (1) verschraubbare isolierende Leiste (16) aufweist, die mit einem Fuß (18) eine Bohrung im Isolierstück (8) durchgreift.

9. Kontaktvorrichtung nach Anspruch 6, **dadurch gekennzeichnet,** daß der Fuß (18) der Leiste (16) Klauen (19) aufweist, die in die Oberfläche des Leitgummis (12) einfassen.

10. Kontaktvorrichtung nach einem der vorherigen Ansprüche, **dadurch gekennzeichnet,** daß das Gehäuse (5) eine der ersten Leiterplatte (1) zugewandte Gewindebohrung aufweist.

11. Kontaktvorrichtung nach einem der vorherigen Ansprüche, **dadurch gekennzeichnet,** daß das LCD-Display (2) am Gehäuse (5) anklemmbar ist.
